# EUROPEAN PATENT APPLICATION

(11) **EP 2 214 306 A1**
(43) Date of publication of application: **04.08.2010**
(21) Application number: 09001268.3
(22) Date of filing: 30.01.2009
(51) Int. Cl.: H03F 1/56

(54) **Low noise amplifier network for wideband signal amplification**

(71) Applicant: Alcatel-Lucent Deutschland AG, 70435 Stuttgart (DE)
(72) Inventor: Wiegner, Dirk, 71409 Schwaikheim (DE); Maier, Simone, 70435 Zuffenhausen (DE)
(74) Representative: Kohler Schmid Möbus

(57) **Abstract**

The invention relates to a low noise amplifier, LNA, network (1a) for wideband signal amplification of a RF signal (2) in at least two frequency bands having different center frequencies (f₁, f₂, f₃). The LNA network (1a) comprises: at least one adaptive matching network (5, 6), the adaptive matching network (5, 6) comprising: at least one frequency matching element (ME1i to ME3i, MElo to ME3o) matched to one of the center frequencies (f₁, f₂, f₃), and at least one switching element (S1i to S3i, S1o to S3o) for switching the at least one frequency matching element (ME1i to ME3i, ME1o to ME3o) in dependence of the center frequency (f₁, f₂, f₃) of the frequency band to be currently amplified. The invention also relates to a base station and to a user terminal (11) comprising such a LNA network (1a), to a radio network (8) comprising at least one such base station or user terminal (11), respectively, as well as to a corresponding method for wideband signal amplification.

## Description

### Background of the Invention

The invention relates to a low noise amplifier, LNA, network for wideband signal amplification of a RF signal in at least two frequency bands having different center frequencies, to a base station and to a user terminal comprising such a LNA network, to a radio network comprising at least one such base station or user terminal, respectively, as well as to a method for wideband signal amplification of a RF signal in at least two frequency bands having different center frequencies.

Today's mobile communication systems are defining various different wireless communication standards like GSM, UMTS or WiMAX which exist in different frequency ranges (900 MHz, 1800 MHz, 2100 MHz, 3500 MHz, etc.). This leads to an exploding product portfolio for system manufacturers. Future multiband/multistandard capable base stations and user terminals will provide the possibility to overcome this situation and to bring benefits for the system manufacturers as well as for the operators, but they require multiband/multistandard capable sub-modules/components. One example for such a component is a low noise amplifier (LNA) module which has to be adapted for signal amplification over a wide frequency range when it is deployed in multiband/multistandard capable base stations or user terminals.

For such multiband/multistandard capable base stations and user terminals, the analog components like the LNAs in the receive path are a kind of bottleneck regarding bandwidth, since typically performance decreases when bandwidth is increased, as currently available state-of-the-art LNAs are mainly designed for single-band applications in order to achieve high performance (low noise figure, high gain, high P1dB, etc.). Although low noise transistors / amplifiers which can be used for wideband LNA designs are principally available, due to the increased bandwidth, they are reduced in their performance.

For example, a solution based on a wideband-capable low noise transistor is known, in which, in order to achieve a constant gain characteristic over a wide frequency range, the biasing on the output side is aligned for constant gain in each frequency band. However, reducing the output voltage to adapt the gain leads to e.g. a decreased P1dB and thus power handling characteristic of the LNA in the affected frequency band.

Thus, there is a lack of appropriate wideband LNA designs for multiband / multistandard capable applications as e.g. required for Software Defined Radio, SDR, applications.

### Object of the Invention

It is the object of the invention to provide: an LNA network, a base station and a user terminal comprising such an LNA network, a radio network comprising at least one such base station and user terminal, respectively, as well as a method for performing wideband signal amplification, all of which allow wideband signal amplification with increased performance.

### Summary of the Invention

This object is achieved by a LNA network as described in the introduction, comprising: at least one adaptive matching network, the adaptive matching network comprising: at least one frequency matching element matched to one of the center frequencies, typically for achieving a low noise characteristic (among others), and at least one switching element for switching the at least one frequency matching element in dependence of the center frequency of the frequency band to be currently amplified.

The basic idea of the invention is to use a wideband capable low noise transistor / amplifier, which can be matched to different frequency bands by adaptive matching networks. Since transistor impedance, noise characteristic etc. for optimum performance are usually frequency dependent, the transistor / amplifier can be matched by use of adaptive matching networks to show the desired properties, in particular a low noise characteristic, for the currently used frequency band, thus leading to an improved performance as compared to a solution based on fixed matching networks.

In one embodiment, the LNA network comprises a low noise transistor, an adaptive input matching network being arranged in a signal path of the RF signal at the input to the low noise transistor, and an adaptive output matching network being arranged in a signal path of the RF signal at the output of the low noise transistor. In this case, the impedance of the low noise transistor is typically unmatched, the adaptive input and output networks providing the impedance matching in order to optimize the design for each addressed frequency band of a wideband/multiband application. This can be achieved by suitable selection of appropriate matching elements as well as suitable positioning of these elements for each addressed frequency band. By on- and off-switching of the particular switching elements and thus also the matching elements, the performance of the LNA network can be optimized for the frequency band which is currently amplified.

In a preferred improvement, a line section of the signal path between the frequency matching element and the input or the output of the low noise transistor is matched to one of the center frequencies, usually to achieve a low noise characteristic (among other things). Typically, the signal path from the input / output of the low noise transistor to the matching elements and the characteristic impedance of the matching elements are selected in such a way that a desired input / output impedance of the LNA network for the currently amplified frequency band can be achieved.

In one development, the low noise transistor has different characteristic input and output impedances, i.e. the low noise transistor is an unmatched transistor. In this case, the adaptive input / output networks are typically used to transform the input / output impedance of the transistor in such a way that the input / output of the overall LNA network have the desired, typically identical characteristic impedance.

In another embodiment, the LNA network comprises a pre-matched low noise amplifier, an adaptive input matching trim network and an adaptive output matching trim network comprising respective trim-lines being arranged at the pre-matched low noise amplifier. The pre-matched low noise amplifier is impedance-matched to a frequency which may correspond e.g. to an average value or to the highest of the center frequencies of the frequency bands to be amplified. For this frequency, the input impedance and the output impedance of the low noise amplifier are matched to desired values which may be different or identical, e.g. both being equal to 50 Ω. The adaptive input and output matching networks are arranged at trim-lines to further enhance the quality of the matching of the LNA network to the frequency band that is currently amplified, in particular with respect to the noise characteristic.

In a development of this embodiment, a line section of the trim-line between the frequency matching element and the pre-matched low-noise amplifier is matched to one of the center frequencies. Typically, the length of the signal path from the pre-matched amplifier to the matching element and the characteristic impedance of the matching element are chosen such that the desired low-noise characteristic together with the desired input / output impedance of the LNA network can be achieved, which is typically 50 Ω. Thus, the performance of a suitably pre-matched low noise amplifier can be optimized versus frequency by suitably on- and off-switching of the switching elements and thus of the matching elements at different positions along the trim-lines which are matched to the different frequency bands to be amplified.

In a further embodiment, the switching element is a PIN diode or a MEM-switch. Due to the fact that low noise amplifier applications are low power applications, currently available switching elements like PIN diodes, which are limited in power handling, can also be used as switching elements.

In another embodiment, the LNA network has the same characteristic input and output impedance, preferably 50 Ω, for the frequency band to be amplified. This can typically be achieved when the switching element and thus the frequency matching element of the currently amplified frequency band are in the ON state, whereas the switching elements which are related to the other (currently not amplified) frequency bands are in the OFF state, such that the frequency matching elements related to these switching elements have no influence on the impedance matching.

Further aspects of the invention are implemented in a base station and a user terminal, each comprising at least one LNA network as described above. Another aspect of the invention is realized in a radio network comprising at least one such base station or user terminal, respectively. As already mentioned in the introduction, LNA networks of the type described above allow base stations and user terminals to operate as multi-band/multi-standard devices, thus enabling applications such as Software Defined Radio etc.

Yet another aspect of the invention is implemented in a method as described in the introduction, the method comprising: amplifying the RF signal in a low noise amplifier, LNA, network, wherein at least one frequency matching element which is matched to one of the center frequencies is switched in dependence of the center frequency of the frequency band to be currently amplified. Typically, the switching element of the frequency band to be currently amplified is set to the ON state, the other switching elements being set to the OFF state, such that only the matching element related to the currently amplified frequency band has an influence on the impedance matching. The switching elements are typically set to the ON or OFF state in dependence of the currently amplified frequency band by a computer program product which may be implemented in a suitable software or hardware, in particular a field programmable gate array (FPGA) or an application-specific integrated circuit (ASIC).

In a variant of this method, at least one input frequency matching element and at least one output frequency matching element are matched in such a way that the characteristic input impedance and the characteristic output impedance of the LNA network have a desired value, preferably 50 Ω, thus allowing an optimal adaptation of the input and output impedance of the LNA network. The person skilled in the art will appreciate that when a pre-matched amplifier is used which may already show the desired input /output impedance of e.g. 50 Ω for the amplified frequency ranges, frequency matching using adaptive matching networks may still be advantageous in order to further improve the performance of the amplification, in particular for achieving a low noise characteristic for the currently amplified frequency band.

Further features and advantages are stated in the following description of exemplary embodiments, with reference to the figures of the drawing, which shows significant details, and are defined by the claims. The individual features can be implemented individually by themselves, or several of them can be implemented in any desired combination.

### Brief Description of the Drawings

Exemplary embodiments are shown in the diagrammatic drawing and are explained in the description below. The following are shown:
- **Fig. 1**: shows a schematic diagram of a first embodiment of the LNA network according to the invention, and
- **Fig. 2**: shows a schematic diagram of a second embodiment of the LNA network according to the invention.

### Detailed Description of Preferred Embodiments

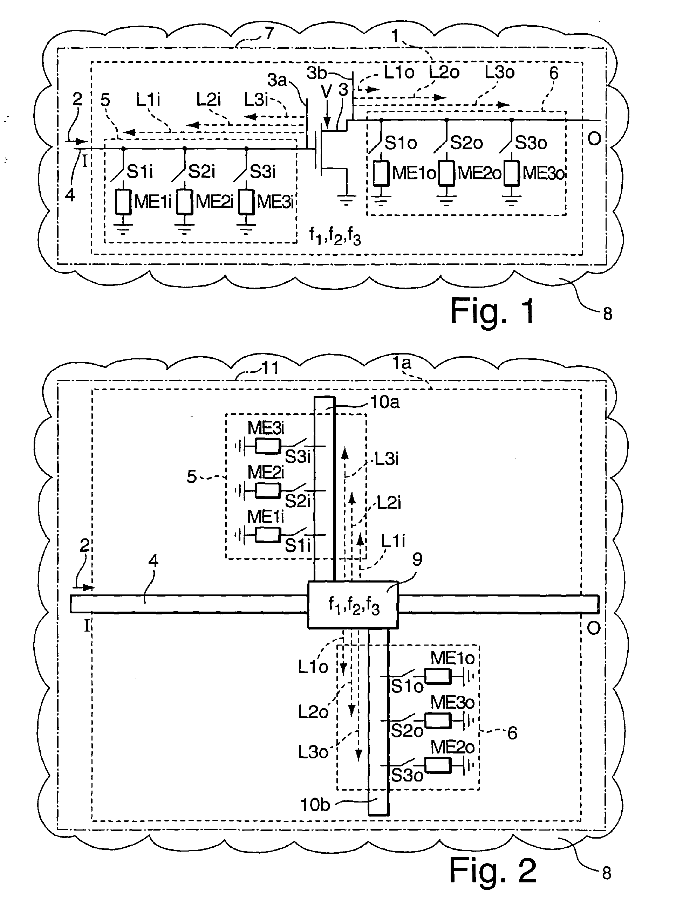

**Fig. 1** shows a LNA network **1** for wideband amplification of an RF signal **2** which is provided to an input **I** of the LNA network 1. In the example of Fig. 1, depending on the wireless communication standard chosen, the RF signal 2 may transport data in one of three frequency ranges having different center frequencies **f₁** = 3500 MHz, **f₂** = 2100 MHz, and **f₃** = 1800 MHz. For amplification of the RF signal 2, a low noise transistor **3** is arranged in the signal path **4** of the RF signal 2, a bias voltage **V** being used for DC biasing of the low noise transistor 3. Typically, the low noise transistor 3 has different characteristic input and output impedances which also change with the center frequency of the currently amplified frequency band.

For performing input impedance matching of the LNA network, an adaptive input matching network **5** is arranged in the signal path 4 to an input **3a** of the low-noise transistor 3. In a similar way, an adaptive output matching network **6** is arranged in the signal path 4 from the output **3b** of the low noise-transistor 3 to the output **O** of the LNA network 1. The adaptive input and output matching networks 5, 6 are used to adapt the characteristic input and output impedance at the input 3a / output 3b of the low noise-transistor 3 in such a way that for the currently amplified frequency band, the input impedance of the low noise-transistor 3 is matched to the input impedance of the LNA network 1 and the output impedance of the low noise-transistor 3 is matched to the output impedance of the LNA network 1, both characteristic LNA network impedances usually having a value of typically 50 Ω.

For this purpose, the input matching network 5 comprises three frequency matching elements **ME1i** to **ME3i**, each being matched to one of the center frequencies f₁ to f₃. The matching elements ME1i to ME3i of the input matching network 5 are connected at one end to respective switching elements **S1i** i to **S3i** and to ground at the other end. Three line sections **L1i** to **L3i** of the signal path 4 between the respective frequency matching elements ME1i to ME3i and the input 3a of the low noise transistor 3 (including the line section of the switching elements Si1 to Si3) are matched to a respective one of the center frequencies f₁, f₂, f₃.

In an analogous way, the output matching network 6 also comprises three frequency matching elements **ME1o** to **ME3o,** each frequency matching element ME1o to ME3o being matched to a respective one of the center frequencies f₁ to f₃ and connected to a respective switching element **S1o** to **S3o.** Furthermore, three line sections **L1o** to **L3o** of the signal path 4 from the output 3b of the low noise transistor 3 to the respective output matching elements ME1o to ME3o are also matched to a respective one of the center frequencies f₁ to f₃.

Due to the fact that low noise amplifier applications are low power applications, PIN diodes which are limited in power handling may be used as switching elements S1i to S3i, S1o to S3o, respectively. Of course, the switching elements S1i to S3i, S1o to S3o may also be implemented in a different way, e.g. as MEM switches etc.

In the following, it is assumed that the RF signal 2 transmits only data in the frequency band related to the first of the center frequencies f₁. In this case, the first switching elements Si1, So1 of the input and output matching networks 5, 6, respectively, are set to the ON (closed) state, i.e. the switching elements Si1, So1 connect the corresponding first frequency matching elements ME1i, ME1o to the signal path 4. The other switching elements S2i, S3i, S2o, S3o are set to the OFF state (open), such that the corresponding frequency matching elements ME2i, ME3i, ME2o, ME3o are disconnected from the signal path 4 and thus do not have an influence on the impedance matching. The switching of the switching elements S1 i to S3i, S1o to S3o in dependence of the currently amplified frequency band may be performed by a suitable control software or hardware which may be implemented in a field programmable gate array (FPGA) or an application-specific integrated circuit (ASIC).

In the above example, the characteristic impedances of the matching elements ME1i, ME1o and of the line sections L1i, L1o are adapted in such a way that the desired input / output impedance of the LNA network 1 (typically 50 Ω) for the first center frequency f₁ is attained. For this purpose, the lengths of the line sections L1i, L1o to the input 3a resp. output 3b of the transistor 3 are usually chosen to be approximately λ₁ / 2, the characteristic impedance of the matching elements ME1i, ME1o being chosen in such a way that a characteristic input / output impedance of e.g. 50 Ω can be attained for the LNA network 1 at the respective center frequency f₁, among other things achieving a low noise characteristic. The characteristic impedances of the other matching elements ME2i, ME3i, ME2o, ME3o and of the corresponding line sections L2i, L3i, L2o, L3o are also matched in such a way that a characteristic input / output impedance of e.g. 50 Ω can be attained for the LNA network 1 at the respective center frequency f₂, f₃ and that among other things a low noise characteristic is achieved.

Therefore, in the arrangement shown in Fig. 1, the adaptive matching networks 5, 6 can be used to optimize the input / output impedance of the LNA network 1 for each addressed frequency band. The person skilled in the art will appreciate that it is also possible to perform the frequency matching as described above to RF signals which transport data in less or more than three frequency bands. Also in this case, the impedance matching can be achieved by suitable selection of appropriate matching elements as well as suitable positioning of the matching elements for each addressed frequency band. By on- and off-switching of the switching elements and thus of the matching elements, the performance of the LNA network can be optimized for the currently amplified frequency band.

The LNA network 1 can be used in a base station **7** of a radio network **8**, as shown in Fig. 1. The person skilled in the art will appreciate that alternatively, the LNA network 1 can also be implemented in a (typically mobile) user terminal of the radio network 8.

**Fig. 2** shows a LNA network **1a** which differs from the LNA network 1 of Fig. 1 essentially in that instead of an (unmatched) low-noise transistor 3, a pre-matched low noise amplifier **9** is used, i.e. an amplifier 9 comprising a transistor (not shown) which is pre-matched and can have preferably identical input / output impedance (e.g. 50 Ohm) for a center frequency which may, for example, correspond to the average of the center frequencies f₁ to f₃ of the frequency bands to be amplified. The pre-matched low noise amplifier 9 provides the possibility to optimize performance by providing adaptive input / output matching trim networks 5, 6 arranged at respective trim-lines **10a, 10b** which strictly speaking do not form part of the signal path 4. The input / output matching networks 5, 6 are implemented in the same way as described above with respect to Fig. 1, the line sections L1i to L3i and L1o to L3o of the trim-lines 10a, 10b between the respective frequency matching elements ME1i to ME3i, ME1o to ME3o and the pre-matched LNA 9 being matched to a respective one of the center frequencies f₁ to f₃ in the way described above.

Also for the LNA network 1 a of Fig. 2, the performance of the pre-matched LNA 9 can be optimized versus frequency by suitably on- and off-switching of the switching elements S1i to S3i, S1o to S3o arranged at different positions along the trim-lines 10a, 10b, such that the characteristic impedance at the input I and the output O of the LNA network 1 a can also be adjusted to a desired value, typically to 50 Ω. The LNA network 1a can be implemented in a (mobile or fixed) user terminal **11** of a radio network 8, as shown in Fig. 2, or alternatively in a base station of the radio network 8.

Necessary requirement for both solutions proposed above is that the used low noise transistor 3 and pre-matched LNA 9, respectively, are wideband capable, i.e. are adapted to amplify the RF signal 2 in the desired frequency bands. The solutions proposed above enable coverage of a wide frequency range with improved performance as compared to conventional wideband LNAs, such that multiband and multi-standard base station / user terminal applications can be supported.

The above description of the preferred embodiments has been given by way of example. From the disclosure given, those skilled in the art will not only understand the present invention and its attendant advantages, but will also find apparent various changes and modifications to the structures and methods disclosed. The applicant seeks, therefore, to cover all such changes and modifications as defined by the appended claims, and equivalents thereof.

## Claims

1. Low noise amplifier, LNA, network (1, 1a) for wideband signal amplification of a RF signal (2) in at least two frequency bands having different center frequencies (f₁, f₂, f₃),
**characterized by**:
at least one adaptive matching network (5, 6), comprising:
at least one frequency matching element (ME1i to ME3i, ME1o to ME3o) matched to one of the center frequencies (f₁, f₂, f₃), and
at least one switching element (S1i to S3i, S1o to S3o) for switching the at least one frequency matching element (ME1i to ME3i, ME1o to ME3o) in dependence of the center frequency (f₁, f₂, f₃) of the frequency band to be currently amplified.

2. LNA network according to claim 1, comprising a low noise transistor (3), an adaptive input matching network (5) being arranged in a signal path (4) of the RF signal (2) at the input (3a) to the low noise transistor (3), an adaptive output matching network (6) being arranged in the signal path (4) of the RF signal (2) at the output (3b) of the low noise transistor (3).

3. LNA network according to claim 2, wherein a line section (L1i to L3i, L10 to L3o) of the signal path (4) between the frequency matching element (ME1i to ME3i, ME1o to ME3o) and the input (3a) or the output (3b) of the low noise transistor (3) is matched to one of the center frequencies (f₁, f₂, f₃).

4. LNA network according to claim 2, wherein the low noise transistor (3) has different characteristic input and output impedances.

5. LNA network according to claim 1, comprising a pre-matched low noise amplifier (9), an adaptive input matching trim network (5) and an adaptive output matching trim network (6) comprising respective trim-lines (10a, 10b) being arranged at the pre-matched low noise amplifier (9).

6. LNA network according to claim 5, wherein a line section (L1 i to L3i, L1o to L3o) of the trim-line (10a, 10b) between the frequency matching element (ME1i to ME3i, ME1o to ME3o) and the pre-matched low-noise amplifier (9) is matched to one of the center frequencies (f₁, f₂, f₃).

7. LNA network according to claim 1, wherein the switching element (S1i to S3i, S1o to S3o) is a PIN diode or a MEM-switch.

8. LNA network according to claim 1, having the same characteristic input and output impedance, preferably 50 Ω.

9. Base station (7) comprising at least one LNA network (1, 1 a) according to claim 1.

10. Radio network (8) comprising at least one base station (7) according to claim 9.

11. User terminal (11) comprising at least one LNA network (1 a) according to claim 1.

12. Radio network (8) comprising at least one user terminal (11) according to claim 11.

13. Method for wideband signal amplification of a RF signal (2) in at least two frequency bands having different center frequencies (f₁, f₂, f₃), the method comprising:
amplifying the RF signal (2) in a low noise amplifier, LNA, network (1, 1 a), wherein at least one frequency matching element (ME1i to ME3i, ME1o to ME3o) which is matched to one of the center frequencies (f₁, f₂, f₃) is switched in dependence of the center frequency (f₁, f₂, f₃) of the frequency band to be currently amplified.

14. Method according to claim 13, wherein at least one input frequency matching element (ME1i to ME3i) and at least one output frequency matching element (ME1o to ME3o) are matched in such a way that the characteristic input impedance and the characteristic output impedance of the LNA network (1, 1 a) have a desired value, preferably 50 Ω.
